Europäisches Patentamt

**European Patent Office**

**Office européen des brevets**

(11) Numéro de publication: **0 107 556**
**B1**

(12) **FASCICULE DE BREVET EUROPEEN**

(45) Date de publication du fascicule du brevet:
**30.03.88**

(51) Int. Cl.⁴: **H 01 L 21/31**

(21) Numéro de dépôt: **83401950.7**

(22) Date de dépôt: **06.10.83**

(54) **Procédé de fabrication d'une résistance électrique dans un matériau semiconducteur polycristallin et dispositif à circuits intégrés en résultant.**

(30) Priorité: **07.10.82 FR 8216803**

(43) Date de publication de la demande:
**02.05.84 Bulletin 84/18**

(45) Mention de la délivrance du brevet:
**30.03.88 Bulletin 88/13**

(84) Etats contractants désignés:
**DE FR GB NL**

(56) Documents cités:
**WO - A - 82/00385**
**US - A - 4 110 776**

**IBM TECHNICAL DISCLOSURE BULLETIN, vol. 24, no. 11B, avril 1982, page 6094, New York, US, H. HINKEL et al.:"Method of influencing the etch rate of PECVD films and applications of the method"**
**JOURNAL OF THE ELECTROCHEMICAL SOCIETY, vol. 130, no. 8, août 1983, page 327C, résumé no. 318, Manchester, New Hampshire, US, J.C. MARCHETAUX et al.:"Electrical properties of argon-implanted polysilicon for VLSI resistors"**

**Le dossier contient des informations techniques présentées postérieurement au dépôt de la demande et ne figurant pas dans le présent fascicule.**

(73) Titulaire: **BULL S.A., 121, avenue de Malakoff, F-75764 Paris Cédex 16 (FR)**

(72) Inventeur: **Boudou, Alain, 94 avenue Gambetta, F-75960 Paris Cedex 20 (FR)**
Inventeur: **Marchetaux, Jean-Claude, 94 avenue Gambetta, F-75960 Paris Cedex 20 (FR)**

(74) Mandataire: **Denis, Hervé et al, BULL S.A. Industrial Property Department 25 avenue de la Grande-Armée, F-75016 Paris (FR)**

## Description

L'invention se rapporte à un procédé de fabrication d'une résistance électrique dans un matériau semi-conducteur polycristallin et au dispositif à circuits intégrés en résultant.

Un dispositif à circuits intégrés se compose essentiellement d'un substrat semi-conducteur cristallin, le silicium ordinairement, dont une face, dite active, incorpore divers composants et comporte un réseau d'interconnexion et des bornes d'entrée-sortie. Les composants sont créés dans le substrat d'une manière classique qui fait intervenir une implantation d'ions actifs relativement au matériau semi-conducteur cristallin du substrat, dans ce sens que ces ions définissent dans ce matériau des régions de conductivité d'un type N ou P. Pour le silicium, les ions implantés sont par exemple l'arsenic, le phosphore ou le bore. Les composants ainsi produits, tels que des transistors à effet de champ du type MOS (Métal-Oxyde-Semi-conducteur), sont reliés entre eux ainsi qu'aux bornes d'entrée-sortie par un réseau conducteur d'interconnexion constitué au-dessus de la face active du substrat par la superposition de couches électriquement conductrices séparées par des couches isolantes. Les couches isolantes intermédiaires sont percées de trous comblés par de la matière électriquement conductrice pour la liaison entre conducteurs de couches voisines. De manière classique également, au moins une couche conductrice du réseau d'interconnexion est constituée par un matériau semi-conducteur polycristallin, tel que le silicium polycristallin, en vue de former dans diverses zones de la couche, des éléments de composants en partie contenues dans le substrat cristallin, tels que les contacts de grille de transistors MOS par exemple, ou des composants à part entière, tels que des résistances électriques.

Selon un procédé antérieur couramment utilisé pour la formation de ces résistances, une première implantation d'ions actifs à faible dose est faite dans tout le matériau semi-conducteur polycristallin constituant la couche du réseau d'interconnexion, de manière à légèrement diminuer sa résistivité jusqu'à obtenir la valeur à partir de laquelle seront définies les résistances à aménager dans ce matériau. La deuxième phase du procédé consiste à masquer les zones du matériau semi-conducteur polycristallin représentatives des résistances à créer, et à faire une seconde implantation ionique à forte dose pour abaisser considérablement la résistance électrique du matériau non masqué et définir ainsi les éléments conducteurs de la couche et éventuellement les jonctions dans le substrat. Une bonne illustration de cette technique est faite par exemple dans l'article de T. Ohzone et coll. paru dans la revue «The Transactions of the IECE of Japan», vol. E. 63, N° 4, April 1980, pages 267–274, ainsi que dans le brevet US-A-4 110 776.

Cette technologie présente de nombreux inconvénients. L'inconvénient majeur réside dans la maîtrise du procédé d'implantation. En effet, il ressort des expériences que la résistance du silicium polycristallin varie d'un facteur de l'ordre de $10^4$ à $10^6$ pour une dose d'ions variant simplement d'un facteur 10. Cette croissance très rapide de la résistance soumet l'ajustement du dosage des ions à des contraintes très sévères.

En outre, les ions implantés diffusent au cours des traitements thermiques successifs impliqués dans le procédé de fabrication du dispositif à circuits intégrés. Il s'ensuit que la concentration des ions dans la zone du matériau destinés à constituer la résistance varie au cours de la fabrication du dispositif à circuits intégrés, d'une manière difficile à contrôler.

Il est par conséquent très difficile à l'heure actuelle de maîtriser suffisamment le procédé de fabrication de résistances dans un matériau semi-conducteur polycristallin pour donner aux résistances les valeurs désirées avec précision. La grande dispersion des valeurs de résistance obtenues fait que cette technologie n'est actuellement applicable que pour la fabrication de résistances très élevées, de l'ordre du Gigohm ou plus. Dans ces gammes de résistances, en effet, des variations de l'ordre du Mégohm sont peu conséquentes et, d'autre part, la pente de la courbe de la résistivité en fonction du dosage des ions est la plus faible, c'est-à-dire moins sensible au dosage. Les dispositifs à circuits intégrés concernés par ce procédé antérieur de fabrication de résistances sont donc notamment les mémoires statiques RAM (Random Access Memory) du type MOS.

D'autre part, la diffusion précitée des ions au cours de la fabrication d'un dispositif à circuits intégrés accroît la taille des zones allouées aux résistances et s'oppose ainsi à une intégration de haute densité.

Un autre procédé de fabrication d'une résistance électrique dans un matériau semi-conducteur polycristallin est décrit dans la demande de brevet WO-A-8 200 385. Le procédé consiste essentiellement à implanter des ions électriquement inactifs dans une zone d'un matériau polycristallin dopé à forte dose d'ions électriquement actifs.

Les ions sont électriquement actifs relativement au matériau semi-conducteur polycristallin lorsque dans ce matériau ils sont donneurs ou accepteurs pour y engendrer des régions d'un type N ou P, tandis que les ions sont électriquement inactifs lorsque dans ce matériau ils ne sont ni donneurs ni accepteurs et demeurent incapables de produire un type de conductivité N ou P dans le matériau.

Autrement dit, ce procédé consiste d'abord à amener le matériau semi-conducteur polycristallin à une faible valeur de résistivité par implantation à forte dose d'ions électriquement actifs dans ce matériau, et à accroître ensuite cette valeur de résistance par implantation d'ions électriquement inactifs dans la zone du matériau délimitant ladite résistance.

Il est précisé que les ions inactifs sont des atomes d'or, d'argent, de zinc ou de cuivre pour le silicium, ou des atomes de fer, de nickel et de chrome pour les matériaux semi-conducteurs des groupes III–V tels que l'arséniure de gallium.

Le procédé décrit dans la demande de brevet WO-A-8 200 385 préconise aussi la formation de défauts ou imperfections dans la structure du matériau semi-conducteur, en substitution ou en addition à l'implantation d'ions inactifs. Le mode de formation de ces défauts ou imperfections qui est décrit dans ladite demande consiste en une implantation ionique. L'exemple pris se réfère à une implantation d'ions de silicium. Cependant, l'expérience montre qu'un recuit restaure pratiquement tout le matériau semi-conducteur, qu'il soit monocristallin ou polycristallin. Par conséquent, l'effet de cette implantation ionique est finalement très faible. C'est pourquoi il est conseillé dans le document antérieur de limiter tout recuit ultérieur à une basse température et de faible durée.

En conclusion, il s'avère que les procédés antérieurs ont les mêmes inconvénients dûs principalement au recuit ultérieur que doit subir au moins une fois un circuit intégré jusqu'à sa fabrication finale.

Le procédé de l'invention reprend le procédé décrit dans la demande de brevet antérieure précitée, mais il a l'avantage d'offrir, d'une part, une grande maîtrise pour la détermination des valeurs de résistance et, d'autre part, une intégration de haute densité.

Le procédé conforme à l'invention pour la fabrication d'une résistance par implantation d'ions électriquement inactifs dans une zone d'un matériau semi-conducteur polycristallin dopé à forte dose d'ions électriquement actifs est caractérisé en ce que les ions électriquement inactifs appartiennent à la famille des gaz rares.

Le dispositif à circuits intégrés résultant de la mise en œuvre de ce procédé, comprenant un matériau semi-conducteur polycristallin contenant des ions électriquement actifs et incluant au moins une zone incluant des ions électriquement inactifs pour constituer une résistance électrique, est caractérisé en ce que les ions électriquement inactifs appartiennent à la famille des gaz rares.

Les caractéristiques et avantages de l'invention ressortiront de la description qui suit, faite en référence aux dessins annexés.

Dans les dessins:

– la figure 1 est une vue partielle de dessus d'un exemple de réalisation d'un dispositif à circuits intégrés conforme à l'invention:

– la figure 2 est une vue en coupe faite selon la ligne II–II représentée sur la figure 1; et

– la figure 3 est un graphe illustrant les variations de la résistivité en fonction du dosage des ions implantés selon un exemple de réalisation conforme à l'invention.

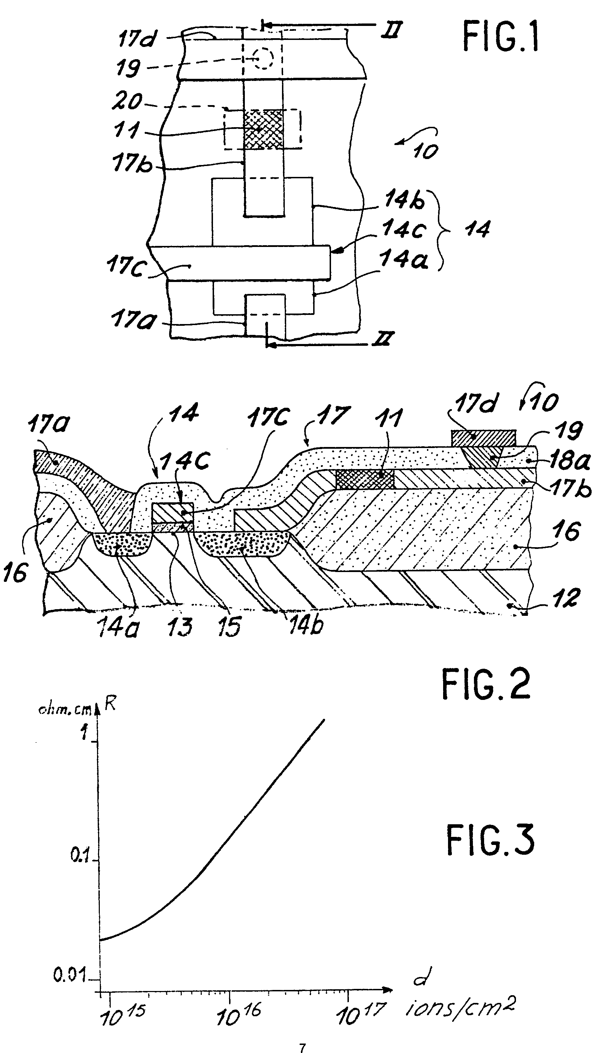

Les figures 1 et 2 illustrent un exemple de réalisation d'une partie d'un dispositif à circuits intégrés (10) incorporant une résistance électrique (11) réalisée conformément à l'invention. La partie illustrée du dispositif (10) fait apparaître un substrat semi-conducteur cristallin (12) tel que le silicium, dont la face active (13) incorpore un transistor à effet de champ du type MOS (14) relié à la résistance (11). Plus précisément, le transistor (14) est formé d'une région de source (14a) et d'une région de drain (14b) par implantation dans le substrat (12) d'ions électriquement actifs, des ions d'arsenic par exemple. La région de grille (14c) du transistor (14) comprend une électrode de grille (17c) formée au-dessus de la face active (13), par l'intermédiaire d'une couche isolante (15), entre les régions de source (14a) et de drain (14b). La face active (13) du substrat (12) supporte une couche isolante (16), en dioxyde de silicium, entourant la zone définissant le transistor (14). Au-dessus de la couche (16) est formé un réseau conducteur d'interconnexion (17) entre les divers composants constitués dans le substrat (12) du dispositif à circuits intégrés (10), tels que le transistor (14).

Le réseau (17) est habituellement formé de couches conductrices superposées, séparées par des couches d'isolation. Les couches conductrices comprennent au moins une couche en matériau semi-conducteur polycristallin dans laquelle on peut former notamment des résistances électriques, et éventuellement des couches métalliques, en aluminium par exemple. Des conducteurs de deux couches voisines sont reliés entre eux par des trous ménagés dans la couche d'isolation intermédiaire et remplis de matière conductrice pour la connexion électrique. Dans l'exemple représenté sur les figures 1 et 2, la couche en matériau semi-conducteur polycristallin comprend deux conducteurs (17b, 17c) constituant respectivement les électrodes de drain et de grille du transistor (14), tandis que la couche métallique supérieure comprend le conducteur (17a) constituant l'électrode de source du transistor (14) et le conducteur (17d) relié à l'électrode de drain (17b) par l'intermédiaire du trou conducteur (19) ménagé dans la couche d'isolation intermédiaire (18a) et de la résistance (11). Pour faciliter la lecture des dessins, les autres couches possibles n'ont pas été représentées.

On pratique d'abord un dopage uniforme à forte dose d'ions actifs dans toute la couche polycristalline pour la rendre très conductrice, puis, par l'intermédiaire d'un masque (20) – représenté sur la figure 1 par un trait mixte – ne mettant à découvert que les zones de la couche où les résistances (11) sont à ménager, on implante dans ces zones de matériau polycristallin, conformément au procédé antérieur décrit dans la demande de brevet WO-A.8 200 385, des ions inactifs en quantité et avec une énergie suffisante pour atteindre la valeur de résistance souhaitée. Le dopage des ions actifs dans le matériau semi-conducteur peut être fait par diffusion au moment du dépôt de ce matériau, ou postérieurement au dépôt, ou par implantation postérieurement au dépôt du matériau.

Selon l'invention, les ions inactifs appartiennent à la famille des gaz rares, tels que l'argon.

La figure 3 présente un graphe illustrant les variations de la résistivité (R) en fonction du dosage (d) d'ions d'argon implantés par centimètre carré selon un exemple de réalisation conforme à l'invention. Selon cet exemple, le corps était du silicium polycristallin de 0,4 micromètre d'épaisseur déposé sous vapeur chimique à basse pression à 630 °C par le procédé dit LPCVD (Low Pressure Chemical Vapor Deposition). Des ions actifs d'arsenic ont d'abord été implantés dans tout le matériau pour le rendre très conducteur, à une dose de $5.10^{15}$ par centimètre carré sous 130 keV. Des ions inactifs d'argon ont ensuite été implantés à 180 keV à doses variables comme indiqué suivant l'axe des abscisses du graphe de la figure 3, le recuit ayant eu lieu sous azote à 1.050 °C pendant 30 minutes. Les échelles en abscisses et en ordonnées sont logarithmiques, les valeurs indiquées en abscisses correspondant à des doses d'ions d'argon (d) variant de $10^{15}$ à $10^{17}$ par centimètre carré, auxquelles correspond des valeurs de résistivité variant de l'ordre de 0,01 ohm.cm à 1 ohm.cm. La figure 3 montre que la courbe obtenue présente avantageusement une partie rectiligne pour des valeurs de résistance supérieures à 0,03 ohm.cm, cette ligne étant légèrement infléchie pour des valeurs inférieures. Dans les conditions précises de cet exemple, une résistance réalisée suivant le procédé de l'invention et ayant une géométrie carrée, telle qu'illustrée à la figure 1, présentera une valeur comprise entre 250 ohms et 25 kilohms, environ. D'autre part, dans le graphe de la figure 3 où les échelles des abscisses et ordonnées sont logarithmiques, il est important de noter que la pente de la partie rectiligne de la courbe est sensiblement égale à l'unité, ce qui se traduirait dans un graphe à échelles linéaires par une courbe elle-même linéaire du type $y = ax + b$. Ceci est remarquable en comparaison des courbes représentatives des procédés antérieurs. Par exemple, sur le premier procédé antérieur cité plus haut, les courbes incorporent une composante principale du type $ax^n$ avec n variant de 4 à 6 qui faisait que la résistance variait d'un facteur de $10^4$ à $10^6$ pour une simple variation d'un facteur 10 du dosage des ions. Il y a donc effectivement un grand contrôle possible du procédé pour obtenir des valeurs de résistance relativement précises. Par ailleurs, l'expérience ne révèle pratiquement pas de variation de la taille des résistances au cours de la fabrication du dispositif à circuits intégrés et se prête donc à une intégration de haute densité.

Bien entendu, l'invention n'est nullement limitée à l'exemple décrit et illustré. C'est ainsi que le matériau semi-conducteur polycristallin dans une zone duquel est prévue une résistance peut être autre chose que du silicium, par exemple des composés de matériaux semi-conducteurs et de métaux réfractaires, et les ions de gaz rare être autre chose que l'argon. D'autre part, compte tenu des valeurs de résistances qu'il est maintenant possible de mettre en œuvre, les composants peuvent être des transistors à effet de champ d'un type quelconque, ou transistors bipolaires, ou d'autres composants actifs ou passifs. Enfin, sachant que toute implantation fait intervenir un recuit, les valeurs des paramètres précités du recuit n'ont été données qu'à titre d'exemple non limitatif, ces valeurs étant quand même d'autant plus significatives qu'elles sont à l'heure actuelle les plus contraignantes.

**Revendications**

1. Procédé de fabrication d'une résistance (11) par implantation d'ions électriquement inactifs dans une zone d'un matériau semi-conducteur polycristallin (17b) dopé à forte dose d'ions électriquement actifs, caractérisé en ce que les ions électriquement inactifs appartiennent à la famille des gaz rares.

2. Procédé selon la revendication 1, caractérisé en ce que le matériau semi-conducteur polycristallin est du silicium.

3. Procédé selon la revendication 1, caractérisé en ce que le matériau semi-conducteur polycristallin est choisi parmi les composés de matériaux semi-conducteurs et de métaux réfractaires.

4. Dispositif à circuits intégrés (10) résultant de la mise en œuvre du procédé défini par l'une des revendications 1 à 3, comprenant un matériau semi-conducteur polycristallin (17b) contenant des ions électriquement actifs et incluant au moins une zone incluant des ions électriquement inactifs pour constituer une résistance électrique (11), caractérisé en ce que les ions électriquement inactifs appartiennent à la famille des gaz rares.

5. Dispositif selon la revendication 4, caractérisé en ce que le matériau semi-conducteur polycristallin est du silicium.

6. Dispositif selon la revendication 4, caractérisé en ce que le matériau semi-conducteur polycristallin est choisi parmi les composés de matériaux semi-conducteurs et de métaux réfractaires.

7. Dispositif selon l'une des revendications 4 à 6, caractérisé en ce que le matériau (17b) constitue au moins une partie d'un réseau conducteur d'interconnexion (17) formé au-dessus d'un substrat semi-conducteur cristallin (12) pour relier les divers composants (14) formés dans ledit substrat.

**Claims**

1. Process for manufacturing a resistor (11) by implantation of electrically inactive ions in an area of a polycrystalline semiconductor material (17b) doped with a strong dose of electrically active ions, characterised in that the electrically inactive ions belong to the family of rare gases.

2. Process according to claim 1, characterised in that the polycrystalline semiconductor material is silicon.

3. Process according to claim 1, characterised in that the polycrystalline semiconductor material is chosen amongst the compounds of semiconductor materials and refractory metals.

4. Integrated circuit device (10) resulting from carrying out the process defined by one of claims 1 to 3, comprising a polycrystalline semiconductor material (17b) containing electrically active ions and including at least one area including electrically inactive ions to form an electrical resistor (11), characterised in that the electrically inactive ions belong to the family of rare gases.

5. Device according to claim 4, characterised in that the polycrystalline semiconductor material is silicon.

6. Device according to claim 4, characterised in that the polycrystalline semiconductor material is chosen amongst the compounds of semiconductor materials and refractory metals.

7. Device according to one of claims 4 to 6, characterised in that the material (17b) constitutes at least a part of an interconnecting conductor lattice (17) formed above a crystalline semiconductor substrate (12) to connect the various components (14) formed in the said substrate.

## Patentansprüche

1. Verfahren zur Herstellung eines Widerstandes (11) durch Implantieren elektrisch inaktiver Ionen in ein Gebiet aus einem polykristallinen Halbleitermaterial (17b), das mit einer hohen Dosis elektrisch aktiver Ionen dotiert ist, dadurch gekennzeichnet, dass die elektrisch inaktiven Ionen zur Edelgasgruppe gehören.

2. Verfahren nach Anspruch 1, dadurch gekennzeichnet, dass das polykristalline Halbleitermaterial Silicium ist.

3. Verfahren nach Anspruch 1, dadurch gekennzeichnet, dass das polykristalline Halbleitermaterial aus den Verbindungen von Halbleitermaterialien und von hochschmelzenden Metallen gewählt wird.

4. Vorrichtung mit integrierten Schaltkreisen (10), die durch Ausführung des Verfahrens nach einem der Ansprüche 1 bis 3 entsteht, mit einem polykristallinen Halbleitermaterial (17b), das elektrisch aktive Ionen enthält und mindestens ein Gebiet umfasst, das elektrisch inaktive Ionen enthält, um einen elektrischen Widerstand (11) zu bilden, dadurch gekennzeichnet, dass die elektrisch inaktiven Ionen zur Edelgasgruppe gehören.

5. Vorrichtung nach Anspruch 4, dadurch gekennzeichnet, dass das polykristalline Halbleitermaterial Silicium ist.

6. Vorrichtung nach Anspruch 4, dadurch gekennzeichnet, dass das polykristalline Halbleitermaterial aus den Verbindungen von Halbleitermaterialien und von hochschmelzenden Metallen gewählt wird.

7. Vorrichtung nach einem der Ansprüche 4 bis 6, dadurch gekennzeichnet, dass das Material (17b) mindestens einen Teil eines Verbindungsleiternetzwerks (17) bildet, das über einem kristallinen Halbleitersubstrat (12) gebildet ist, um die verschiedenen Schaltungselemente (14), die in diesem Substrat gebildet sind, zu verbinden.

FIG.1

FIG.2

FIG.3